Europäisches Patentamt

European Patent Office

Office européen des brevets

(11) Publication number: **0 143 259**
**B1**

(12) **EUROPEAN PATENT SPECIFICATION**

(45) Date of publication of patent specification: **09.09.87**

(51) Int. Cl.⁴: **H 01 L 29/743**

(21) Application number: **84111540.5**

(22) Date of filing: **27.09.84**

(54) Composite type thyristor.

(30) Priority: **30.09.83 JP 182679/83**

(43) Date of publication of application:
**05.06.85 Bulletin 85/23**

(45) Publication of the grant of the patent:
**09.09.87 Bulletin 87/37**

(84) Designated Contracting States:
**DE FR GB**

(56) References cited:
**EP-A-0 015 835**
**GB-A-2 014 364**
**US-A-4 009 059**
**US-A-4 357 621**

(73) Proprietor: **Kabushiki Kaisha Toshiba**
**72, Horikawa-cho Saiwai-ku**
**Kawasaki-shi Kanagawa-ken 210 (JP)**

(72) Inventor: **Sakurai, Hiroshi c/o Patent Division**
**Kabushiki Kaisha Toshiba 1-1 Shibaura 1-chome**
**Minato-ku Tokyo 105 (JP)**
Inventor: **Iwasaki, Masami c/o Patent Division**
**Kabushiki Kaisha Toshiba 1-1 Shibaura 1-chome**
**Minato-ku Tokyo 105 (JP)**

(74) Representative: **Lehn, Werner, Dipl.-Ing. et al**
**Hoffmann, Eitle & Partner Patentanwälte**
**Arabellastrasse 4**
**D-8000 München 81 (DE)**

Courier Press, Leamington Spa, England.

## Description

The present invention relates to a composite type thyristor in which a thyristor and a high-speed diode are monolithically formed.

Generally, in a gate turn-off thyristor (hereafter, referred to as a GTO) to be used with large amounts of electric power, a high voltage withstanding capacity of thousands of volts is required. On the other hand, when using the above GTO in a circuit having an inductance (L), it should not be broken due to an excessive voltage generated by this inductance. Due to this, as a GTO is to be used with large amounts of electric power, in order to prevent breakage due to excessive voltage, whereby the current supplying direction is reversed as compared with that of the GTO, a high-speed diode, i.e., a free wheel diode (hereinafter, referred to as an FWD) is connected. As the above FWD, a diode having a high circuit operating speed is needed, and a short reverse recovery time is required. Therefore, a composite type thyristor, monolithically formed, is realized by selectively diffusing a lifetime killer such as gold or the like in only the diode region.

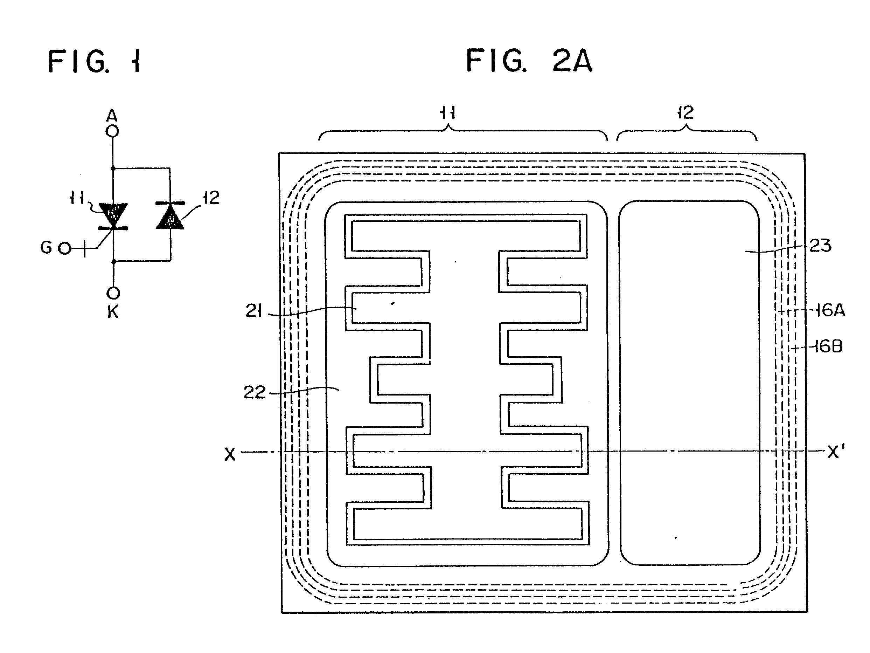

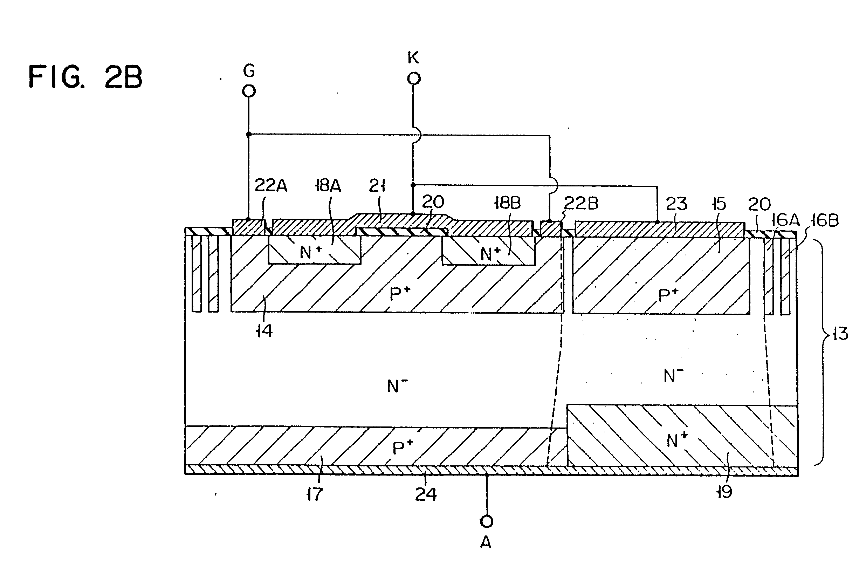

Fig. 1 shows an equivalent circuit of a conventional composite type thyristor formed by reversely connecting the current supplying directions of the above GTO and FWD. Figs. 2A and 2B, respectively show a pattern plan view of a prior art realization of the equivalent circuit of Fig. 1 and a cross-sectional constitutional diagram taken along the line of X—X' of this pattern plan view. In Fig. 1, a cathode of an FWD 12 is connected to an anode A of a GTO 11, and an anode of the FWD 12 is connected to a cathode K of the GTO 11. The process of forming such a GTO 11 and FWD 12 on the same semiconductor substrate is as explained below. Namely, acceptor impurity is selectively diffused in one surface of an $N^-$ type semiconductor substrate 13, and a $P^+$ type base (gate) region 14, an anode region 15 of the FWD 12, and guard rings 16A and 16B are respectively formed so that they have the same depth of diffusion. On the other surface side of the semiconductor substrate 13, the acceptor impurity is selectively diffused and a $P^+$ type emitter region 17 is formed. Next, donor impurity with a high concentration is selectively diffused in the gate region 14, and $N^+$ type emitter regions 18A and 18B are formed. In addition, on the other surface side of the semiconductor substrate 13 corresponding to the anode region 15 of the FWD 12, the donor impurity with a high concentration is diffused, and a cathode region 19 of the FWD 12 is formed. The region where the GTO 11 is formed is masked by, e.g., film oxide or the like, and a lifetime killer such as gold or the like is selectively diffused in the FWD 12 under a predetermined temperature condition (e.g., at 900°C). Due to this, the lifetime of a minority carrier of the FWD 12 is set to be short (for example, to a time interval on the order of a few μsec when the withstanding voltage is 1300 V). Thereafter, a film oxide 20 is selectively formed on one surface of the semiconductor substrate 13. A cathode electrode 21 of the GTO 11 is formed on the exposed surfaces of the emitter regions 18A and 18B and on the film oxide 20 formed on the gate region 14 between these emitter regions 18A and 18B. On the other hand, gate electrodes 22A and 22B are formed on the exposed surface of the gate region 14, while an anode electrode 23 is formed on the exposed surface of the anode region 15 in the FWD 12. The cathode electrode 21 of the GTO 11 is connected to the anode electrode 23. A common electrode 24, constituted by integrating the anode electrode of the GTO 11 and the cathode electrode of the FWD 12, is formed on the other surface side of the semiconductor substrate 13. Thus, a composite type thyristor of which the GTO 11 and FWD 12 are connected such that their current supplying directions are opposite to each other is monolithically formed.

In the above-mentioned constitution, the GTO 11 needs a long (tens of μsec) carrier lifetime in order to reduce loss due to the voltage drop. On the other hand, with respect to the FWD 12, it is necessary to set the carrier lifetime to be short (a few μsec)) in order to reduce loss due to the stored carrier after the free wheel current flows therethrough. Therefore, as mentioned above, the lifetime killer is selectively diffused in only the region where the FWD 12 is formed. However, since the GTO 11 is formed adjacent to the FWD 12, when a steep leading voltage is applied between the anode A and the cathode K of the GTO 11, immediately after the free wheel current flows through the FWD 12, the carriers stored between the anode region 15 of the FWD 12 and the $N^-$ type region (semiconductor substrate 13) due to the free wheel current, are allowed to flow through the $N^-$ type region into the gate region 14 of the GTO 11, so that the GTO 11 is retriggered. Such an operation causes a malfucntion, and in the case where the applied voltage between the anode A and the cathode K of the GTO 11 is high, it will cause permanent breakage of the GTO 11.

In addition, as mentioned above, in the case of selectively diffusing the lifetime killer in only the region where the FWD 12 is formed, the diffusion speed of the lifetime killer is high, so that the lifetime killer will be extended in a wide range of the lateral direction as well. Thus, the lifetime of the minority carrier in the gate region 14 of the GTO 11 will be partially reduced due to this influence. Therefore, the ON-voltage of the GTO 11 increases and the current distribution becomes uneven, causing a drawback such that the GTO 11 will be easily broken. Composite type thyristors comprising isolation regions which consist of annular grooves and barriers of diffused heavy metals or crystal lattice faults are described in US—A—4 009 059 and GB—A—2 014 364, respectively. These isolation regions traverse at least the high resistive middle layer.

It is therefore an object of the present invention to provide a composite type thyristor which can prevent the retrigger of the thyristor due to the carrier stored in the diode and can reduce the diffusion of the lifetime killer into the region where the thyristor is formed.

According to the present invention, there is provided a composite type thyristor as set out in the first part of claim 1 further comprising: an isolating region of the second conductivity type formed by the diffusion process in the surface portion of said semiconductor substrate at an area located between said gate region and said anode region, said isolation region having the same diffusion depth as that of said gate region.

With such an arrangement, it is possible to prevent the retrigger of the thyristor due to the carrier stored in the diode, and it is also possible to reduce the diffusion of the lifetime killer into the region where the thyristor is formed.

This invention can be more fully understood from the following detailed description when taken in conjunction with the accompanying drawings, in which:

Fig. 1 is an equivalent circuit diagram of a conventional composition type thyristor;

Fig. 2A is a plan view showing an example of a pattern arrangement of the circuit of Fig. 1;

Fig. 2B is a cross sectional constitutional diagram of Fig. 2A;

Fig. 3A is a plan view showing a pattern arrangement of a composite type thyristor according to an embodiment of the present invention;

Fig. 3B is a cross sectional constitutional diagram of Fig. 3A;

Fig. 4 is an enlarged diagram of the cross sectional structure of guard rings in Figs. 3A and 3B; and

Figs. 5 and 6 are sectional views of other composite type thyristors according to the invention.

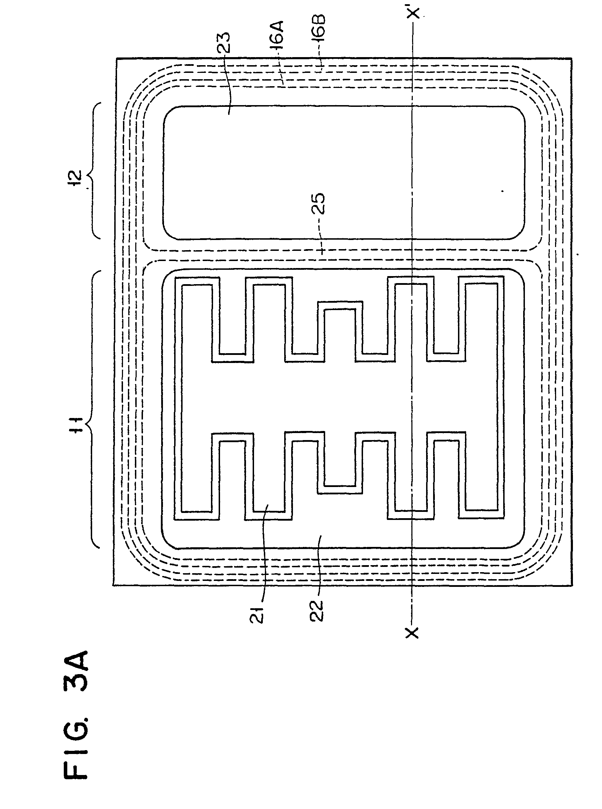

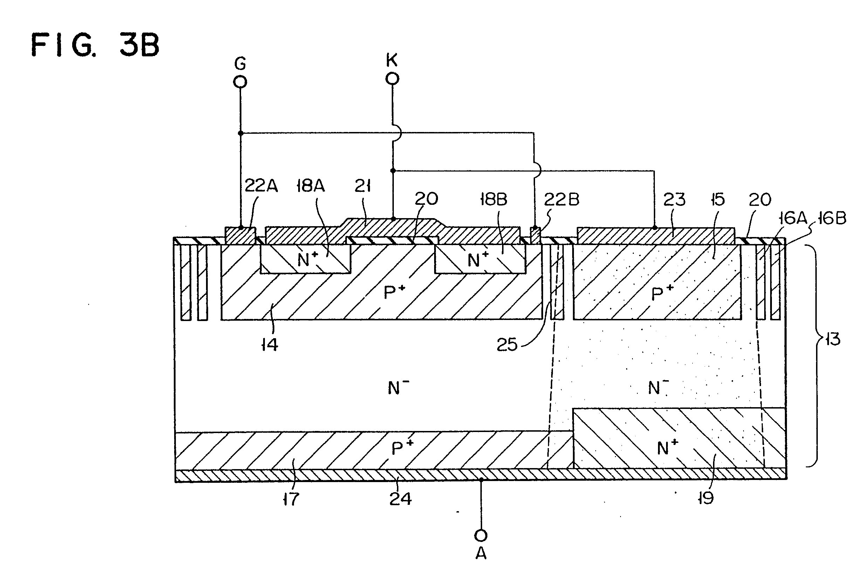

Fig. 3A shows a pattern plan view of a composite type thyristor according to one embodiment of the present invention, and Fig. 3B shows a cross sectional constitutional diagram taken along the line of X—X' thereof. Namely, between the region where the GTO 11 is formed and the region where the FWD 12 is formed in Figs. 2A and 2B, the guard ring 16A formed so as to surround these regions is branched and extended. A part of the guard ring 16A is used as an isolating region 25. Due to this isolating region, the gate region 14 of the GTO 11 and the anode region 15 of the FWD 12 are separated.

Such an arrangement is formed in the manner as will be explained below. First, the acceptor impurity is selectively diffused in one surface of the N⁻ type semiconductor substrate 13, and the P⁺ type base (gate) region 14, the anode region 15 of the FWD 12, and the guard rings 16A and 16B are respectively formed so they have the same diffusion depth. The guard ring 16A is formed so as to surround the region where the GTO 11 is formed and the region where the FWD 12 is formed, respectively. The guard ring 16A between the region for forming the GTO 11 and the region for forming the FWD 12 is used as the isolating region 25. On the other hand, the guard ring 16B is formed so as to surround the region for forming the GTO 11 and the region for forming the FWD 12 along the outer periphery of the guard ring 16A. The acceptor impurity is selectively diffused in the surface on the other side of the semiconductor substrate 13, and the P⁺ type emitter region 17 is formed. Next, donor impurity having a high concentration is selectively diffused in the gate region 14, and the N⁺ type emitter regions 18A and 18B are formed. In addition, in the surface on the other side of the semiconductor substrate 13 corresponding to the anode region 15 of the FWD 12, the donor impurity having a high concentration is diffused, and the cathode region 19 of the FWD 12 is formed in contact with the emitter region 17. A lifetime killer such as gold or the like is selectively diffused in the FWD 12 under a predetermined temperature condition (for example, at 900°C) while masking the region for forming the GTO 11 by means of, e.g., film oxide or the like. Due to this, the lifetime of the minority carrier of the FWD 12 is set to be short (e.g., into a time on the order of about a few μsec when a withstanding voltage is 1300 V). Thereafter, the film oxide 20 is selectively formed on one surface of the semiconductor substrate 13. The cathode electrode 21 of the GTO 11 is formed on the exposed surfaces of the emitter regions 18A and 18B and on the film oxide 20 formed on the gate region 14 between these emitter regions 18A and 18B. In addition, the gate electrodes 22A and 22B are formed on the exposed surface of the gate region 14, while the anode electrode 23 is formed on the exposed surface of the anode region 15 in the FWD 12. The cathode electrode 21 of the GTO 11 is connected to the anode electrode 23. On the other hand, on the other surface side of the semiconductor substrate 13, the common electrode 24 constituted by integrating the anode electrode of the GTO 11 and the cathode electrode of the FWD is formed. Thus, a composite type thyristor of which the GTO 11 and the FWD 12 are connected, such that their current supplying directions are opposite to each other, is monolithically formed.

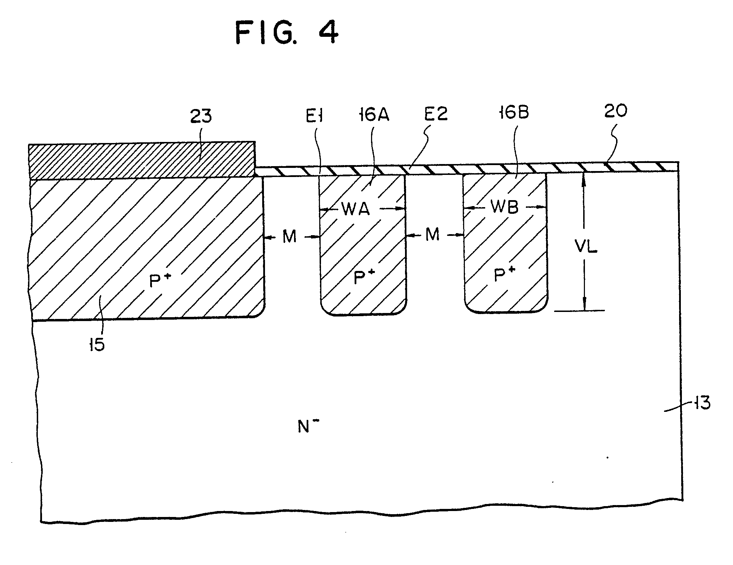

Fig. 4 shows an enlarged diagram of the guard ring layers 16A and 16B. Such P⁺ type guard rings are broadly used for allowing the device with a planar structure to withstand a high voltage. The withstanding voltage of the device in which the guard rings are formed differs depending upon the number of guard rings and a distance M therebetween. A breakdown voltage becomes the breakdown voltage at the portion of the depletion layer extending from the guard ring layer 16B on the side of its outermost rim. Therefore, to obtain a desired withstanding voltage, it is necessary to consider various knds of factors such as an impurity concentration of the semiconductor substrate 13, a diffusion depth VL of the P⁺ base layer, surface charges, and the like. Among them, distances from the main junction 15 to the guard rings 16A and 16B are important. Widths WA and WB of the guard rings 16A and 16B are irrelevant. This is because the areas between the edges E1 and E2 of the guard ring 16A have equal potential. Although the width of the guard ring at the corner of the cross point between the guard ring layer at the portion serving as the isolating region 25 and the guard ring 16A at the peripheral portion is wide, the withstanding voltage does not decrease since the withstanding voltage of the device is independent of the width W of the guard ring as mentioned above.

With such an arrangement, even when a steep leading voltage is applied between the anode A and the cathode K of the GTO 11 immediately after the reverse current has finished flowing through the FWD 12, the inflow of the carrier, stored between the anode region 15 of the FWD 12 and the $N^-$ type region (semiconductor substrate 13), into the gate region 14 is prevented by the isolating region 25, so that the retrigger can be prevented.

In addition, when the lifetime killer is selectively diffused in the region forming the FWD 12, the diffusion in the lateral direction of the lifetime killer is obstructed since the concentration of the isolating region 25 is higher than that of the $N^-$ type semiconductor substrate 13. Thus, the influence on the characteristic of the GTO 11 decreases, and it is possible to make the current uniform and to improve the breakage withstanding voltage.

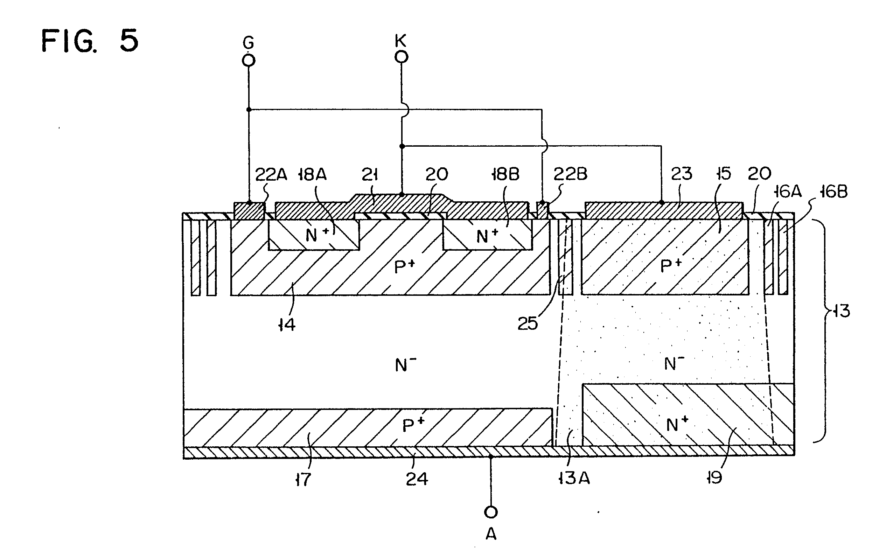

Fig. 5 shows a cross sectional constituting diagram of a composite type thyristor according to another embodiment of the present invention. Namely, the $P^+$ type emitter region 17 and the cathode region 19 of the FWD 12 in Fig. 3B are formed are formed so as to be isolated by a predetermined distance. In the diagram, the same parts and components as those shown in Fig. 3B are designated by the same reference numerals, and their detailed descriptions will be omitted.

With such an arrangement, since an $N^-$ type region 13A having a low concentration is used an isolating region between the $P^+$ type emitter region 17 and the cathode region 19, when a lifetime killer such as gold or the like is diffused into the region for forming the FWD 12, gold of a high concentration is diffused in the $N^-$ type region 13A. Therefore, the lifetime of the minority carriers in the $N^-$ type region 13A can be reduced more than that in the region for forming the FWD 12. Thus, the inflow of the carriers from the side of the FWD 12 into the side of the GTO 11 can be suppressed, and this makes it possible to more effectively prevent the retrigger and breakage and the like of the GTO 11.

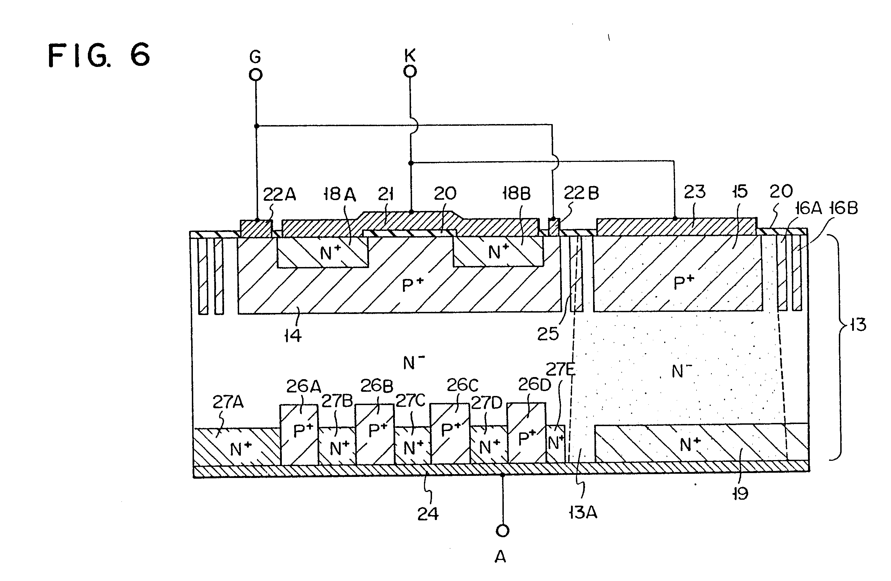

Fig. 6 is a cross sectional view of still another composite type thyristor according to the present invention. The same parts and components as those shown in Fig. 5 are denoted by the same numerals and will not be described in detail. In this thyristor, the anode of a GTO 11 is of the short-circuited emitter structure. First emitter regions, i.e., $P^+$ type impurity diffusion regions 26A, 26B, 26C and 26D, and first base regions (anoder short-circuiting regions), i.e., $N^+$ type impurity diffusion regions 27A, 27B, 27C and 27D, are alternately arranged. The first emitter regions 26A—26D are connected by electrodes 24 to the first base regions 27A—27D by electrodes 24 formed on the anode-side surface of the GTO 11. A second base region (gate region) 14 of $P^+$ type is formed on the cathode-side surface of the GTO 11. Second emitter region 18A and 18B of $N^+$ type are formed in the surface region of the second base region 14.

Also in this composite type thyristor, the GTO 11 is isolated from an FWD 12 by an isolating region 25 and an $N^-$ type region 13A. Hence, the retrigger, beakage and the like of the GTO 11 can be effectively prevented.

On the other hand, although the GTO has been described in the foregoing embodiments, the present invention obviously can similarly be applied to other various kinds of semiconductor devices such as a reverse conduction thyristor for use with large electric power or the like.

**Claims**

1. A composite type thyristor comprising a semiconductor substrate (13) of a first conductivity type, a thyristor gate region (14) of a second conductivity type formed by a diffusion process in one surface portion of said semiconductor substrate (13), a diode anode region (15) of the second conductivity type formed by the diffusion process in the surface portion of said semiconductor substrate (13) such that said anode region (15) is separated from said gate region (14), a thyristor first emitter region (18A, 18B) of the first conductivity type formed by the diffusion process in the surface portion of said gate region (14), a thyristor second emitter region (17) of the second conductivity type formed by a diffusion process in the other surface portion of said semiconductor substrate (13) at an area corresponoding to said gate region (14), a diode cathode region (19) of the first conductivity type formed in the other surface portion of said semiconductor substrate (13) at an area corresponding to said anode region (15), a thyristor gate electrode (22A, 22B) formed on said gate region (14), a thyristor cathode electrode (21) formed on said first emitter region (18A, 18B), a diode anode electrode (23) formed on said anode region (15) and electrically connected to said thyristor cathode electrode (21), and a common electrode (24) formed on said thyristor second emitter region (17) and said diode cathode region (19) and acting as a thyristor anode electrode and a diode cathode electrode, in which a lifetime killer is diffused within said diode anode and cathode regions (15, 19) and within that part of said semiconductor substrate (13) which lies between said diode anode and cathode regions (15, 19), characterized in that said thyristor further comprises an isolation region (25) of the second conductivity type formed by the diffusion process in the surface portion of said semiconductor substrate (13) at an area located between said gate region (14) and said anode region (15), said isolation region (25) having the same diffusion depth as that of said gate region (14).

2. A thyristor according to claim 1, characterized in that said isolation region (25) is part of a guard ring (16A) which is branched and extended.

3. A thyristor according to claim 1, characterized by further comprising a separating region (13A) of the semiconductor substrate between said thyristor second emitter region (17) and said diode cathode region (19).

4. A thyristor according to claim 1, characterized in that the thyristor second emitter region (17) has an emitter shortcircuited structure.

**Patentansprüche**

1. Thyristor vom zusammengesetzten Typ mit einem Halbleitersubstrat (13) eines ersten Leitfähigkeitstyps, einem durch einen Diffusionsvorgang in einem Oberflächenteil des Halbleitersubstrats (13) gebildeten Thyristor-Gatter-Bereich (14) eines zweiten Leitfähigkeitstyps, einem Dioden-Anoden-Bereich (15) des zweiten Leitfähigkeitstyps, der durch den Diffusionsvorgang in dem Oberflächenteil des Halbleitersubstrats (13) derart ausgebildet ist, daß der Anodenbereich (15) von dem Gatterbereich (14) getrennt ist, einem ersten, durch den Diffusionsvorgang in dem Oberflächenteil des Gatterbereichs (14) gebildeten Thyristor-Emitter-Bereich (18A, 18B) des ersten Leitfähigkeitstyps, einem zweiten, durch einen Diffusionsvorgang in dem anderen Oberflächenteil des Halbleitersubstrats (13) an einer Fläche entsprechend dem Gatterbereich (14) ausgebildeten Thyristor-Emitter-Bereich (17) des zweiten Leitfähigkeitstyps, einem in dem anderen Oberflächenteil des Halbleitersubstrats (13) an einer Fläche entsprechend dem Anodenbereich (15) ausgebildeten Dioden-Kathoden-Bereich (19) des ersten Leitfähigkeitstyps, einer auf dem Gatterbereich (14) ausgebildeten Thyristor-Gatter-Elektrode (22A, 22B), einer auf dem ersten Emitter-Bereich (18A, 18B) ausgebildeten Thyristor-Kathodenelektrode (21), einer auf dem Anodenbereich (15) ausgebildeten und mit der Thyristor-Kathodenelektrode (21) elektrisch verbundenen Dioden-Anodenelektrode (23) und einer auf dem zweiten Thyristor-Emitter-Bereich (17) und auf dem Dioden-Kathoden-Bereich (19) ausgebildeten gemeinsamen Elektrode (24), die wie eine Thyristor-Anodenelektrode und eine Dioden-Kathodenelektrode wirkt, in die ein Lebensdauerverkürzer innerhalb der Dioden-Anoden- und Kathoden-Bereich (15, 19) und innerhalb jenes Teils des Halbleitersubstrats (13) eindiffundiert ist, der zwischen den Dioden-Anoden- und Kathodenbereichen (15, 19) liegt,

dadurch gekennzeichnet, daß der Thyristor weiter einen Isolationsbereich (25) des zweiten Leitfähigkeitstyps enthält, der durch den Diffusionsvorgang in dem Oberflächenteil des Halbleitersubstrats (13) an einer zwischen dem Gatterbereich (14) und dem Anodenbereich (15) befindlichen Fläche ausgebildet ist, wobei der Isolationsbereich (25) die gleiche Diffundierungstiefe wie der Gatterbereich (14) aufweist.

2. Thyrisotor nach Anspruch 1, dadurch gekennzeichnet, daß der Isolationsbereich (25) Teil eines Schutzrings (16A) ist, der verzweigt und erweitert ist.

3. Thyristor nach Anspruch 1, dadurch gekennzeichnet, daß weiter ein Trennungsbereich (13A) des Halbleitersubstrats zwischen dem zweiten Thyristor-Emitter-Bereich (17) und dem Dioden-Kathoden-Bereich (19) vorgesehen ist.

4. Thyristor nach Anspruch 1, dadurch gekennzeichnet, daß jeder zweite Thyristor-Emitter-Bereich (17) eine kurzgeschlossene Emitter-Struktur aufweist.

**Revendications**

1. Thyristor de type composite comprenant un substrat semiconducteur (13) d'un premier type de conductivité, une région de gâchette de thyristor (14) d'un second type de conductivité formé par un processus de diffusion dans une partie de surface du substrat semiconducteur (13), une région d'anode de diode (15) du second type de conductivité formée par diffusion dans la partie de surface du substrat semiconducteur (13) de sorte que la région d'anode (15) est séparée de la région de gâchette (14), une première région d'émetteur de thyristor (18A, 18B) du premier type de conductivité formée par diffusion dans la partie de surface de la région de gâchette (14), une seconde région d'émetteur de thyristor (17) du second type de conductivité formée par diffusion dans l'autre partie du surface due substrat semiconducteur (13) au niveau d'une zone correspondant à la région de gâchette (14), une région de cathode de diode (19) du premier type de conductivité formée dans l'autre partie superficielle du substrat semiconducteur (13) au niveau d'une zone correspondant à la région d'anode (15), une électrode de gâchette de thyristor (22A—22B) formée sur la région de gâchette (14), une électrode de cathode de thyristor (21) formée sur la première région d'émetteur (18A—18B), une électrode d'anode de diode (23) formée sur la région d'anode (15) et électriquement connectée à l'électrode de cathode du thyristor (21), et une électrode commune (24) formée sur la seconde région d'émetteur du thyristor (17) et al région de cathode de diode (19) et agissant en tant que'électrode d'anode du thyristor et électrode de cathode de la diode, dans laquelle un tueur de durée de vie est diffusé dans les régions d'anode et de cathode de la diode (15, 19) et à l'intérieur de la partie du substrat semiconducteur (13) qui se trouve entre les régions d'anode et de cathode de la diode (15, 19), caractérisé en ce que le thyristor comprend en outre une région d'isolement (25) du second type de conductivité formé par un processus de diffusion dans la partie superficielle du substrate semiconducteur (13) au niveau d'une zone située entre la région de gâchette (14) et la région d'anode (15), ladite région d'isolement (25) ayant la même profondeur de diffusion que celle de la région de gâchette (14).

2. Thyristor selon la revendication 1, caractérisé en ce que la région d'isolement (25) constitue une partie d'un anneau de garde (16A) qui constitue une dérivation et une extension.

3. Thyristor selon la revendication 1, caractérisé en ce qu'il comprend en outre une région de séparation (13A) du substrat semiconducteur entre la seconde région d'émetteur du thyristor (17) et la région de cathode de diode (19).

4. Thyristor selon la revendication 1, caractérisé en ce que la second région d'émetteur (17) du thyristor présente une structure à court-circuit d'émetteur.

# FIG. 1

# FIG. 2A

0 143 259

FIG. 2B

G    K

22A  18A  21  20  18B  22B  23  15  20  16A 16B

N⁺    N⁺    P⁺

14    P⁺

N⁻    N⁻

P⁺    N⁺

17    24    19

A

0 143 259

2

# FIG. 3A

FIG. 3B

0 143 259

# FIG. 4

FIG. 5

0 143 259

FIG. 6

0 143 259